# FASCICULE DE BREVET EUROPEEN

(11) **EP 3 175 484 B1**
(45) Date de publication et mention de la délivrance du brevet: **27.05.2020**
(21) Numéro de dépôt: 15753728.3
(22) Date de dépôt: 23.07.2015
(51) Int. Cl.: H01L 29/49, H01L 29/786

(54) **DISPOSITIF ELECTRONIQUE ET SON PROCEDE DE FABRICATION**
ELEKTRONISCHES BAUELEMENT UND DESSEN HERSTELLUNGSVERFAHREN
ELECTRONIC DEVICE AND ITS FARBICATION METHOD

(30) Priorité: 29.07.2014 FR 1457328
(43) Date de publication de la demande: 07.06.2017
(73) Titulaire: Commissariat à l'Energie Atomique et aux Energies Alternatives, 75015 Paris (FR)
(72) Inventeur: BENWADIH, Mohammed, 94500 Champigny-sur-Marne (FR); COPPARD, Romain, 38500 Voiron (FR)
(74) Mandataire: Cabinet Beaumont
(86) Numéro de dépôt international: PCT/FR2015/052042
(87) Numéro de publication internationale: WO 2016/016554

(56) Documents cités:
- JP-A- 2002 076 356
- US-A1- 2006 003 485
- US-A1- 2009 159 880

## Description

La présente demande de brevet revendique la priorité de la demande de brevet français FR14/57328.

### Domaine

La présente demande concerne un dispositif électronique et son procédé de fabrication.

### Exposé de l'art antérieur

Certains composants électroniques d'un dispositif électronique comprennent une portion semiconductrice en contact avec une portion isolante. Un exemple d'un tel composant électronique correspond à un transistor à effet de champ dans lequel la portion isolante correspond à l'isolant de grille et dans lequel le canal est formé dans la portion semiconductrice. Un autre exemple de composant électronique correspond à une capacité métal-isolant-semiconducteur. Un autre exemple de composant électronique correspond à des pistes en matériau semiconducteur isolées latéralement les unes des autres par un matériau isolant.

Certaines propriétés du dispositif électronique peuvent dépendre de l'état de l'interface entre la portion semiconductrice et la portion isolante. Il est généralement souhaitable que l'interface entre la portion semiconductrice et la portion isolante ait le moins de défauts possible.

Lorsque le procédé de fabrication du dispositif électronique est un procédé par voie sèche, la portion semiconductrice et la portion isolante peuvent être réalisées par dépôt physique en phase vapeur ou PVD (sigle anglais pour Physical Vapor Deposition) ou par dépôt chimique en phase vapeur ou CVD (sigle anglais pour Chemical Vapor Deposition). Ces procédés nécessitent l'utilisation d'un réacteur dans lequel un vide partiel est réalisé. Une interface de bonne qualité peut généralement être obtenue entre la portion isolante et la portion semiconductrice.

La réalisation de dispositifs électroniques par des procédés par voie humide, notamment par des procédés sol-gel, ne nécessite pas l'utilisation d'un réacteur et permet de façon avantageuse de réaliser des structures de grandes dimensions. De plus, les procédés sol-gel peuvent être mis en oeuvre à la pression atmosphérique et permettent de commander avec précision la composition des couches obtenues.

Un inconvénient des procédés de fabrication par voie humide est que les interfaces entre la portion isolante et la portion semiconductrice peuvent comprendre un nombre important de défauts.

Le document JP2002076356 décrit un transistor comprenant une couche semiconductrice en ZnO dopé, et un isolant de grille en ZnO dopé. Le document US2009/159880 décrit un procédé pour transformer un matériau précurseur en un matériau fonctionnel en utilisant la chaleur générée par irradiation d'une surface adjacente absorbant les ondes électromagnétiques.

### Résumé

Un objet d'un mode de réalisation vise à pallier tout ou partie des inconvénients des dispositifs électroniques comprenant une portion semiconductrice et une portion isolante et de leurs procédés de fabrication décrits précédemment.

Un autre objet d'un mode de réalisation est que la portion semiconductrice et la portion isolante sont réalisées par des procédés de fabrication par voie humide.

Un autre objet d'un mode de réalisation est que l'interface entre la portion semiconductrice et la portion isolante comprend peu de défauts.

Ainsi, un mode de réalisation prévoit un dispositif électronique réalisé selon le procédé de l'une quelconque des revendications 1 à 6, comprenant au moins une première portion à base d'un oxyde métallique au contact d'une deuxième portion à base dudit oxyde métallique, la première portion étant semiconductrice et la deuxième portion étant isolante électriquement.

Selon un mode de réalisation, l'oxyde métallique est choisi parmi le groupe comprenant l'oxyde de zinc (ZnO), l'oxyde d'indium (In₂O₃), l'oxyde d'indium et de zinc (In-Zn-O), les oxydes In-X-Zn-O où X est choisi parmi le groupe comprenant le gallium (Ga), l'antimoine (Sb), l'étain (Sn), le magnésium (Mg), le béryllium (Be), l'yttrium (Y), l'argent (Ag), l'aluminium (Al), le calcium (Ca) et le nickel (Ni) et les oxydes Sn-X-Zn-O où X est choisi parmi le groupe comprenant le gallium (Ga), l'antimoine (Sb), le magnésium (Mg), le béryllium (Be), l'yttrium (Y), l'argent (Ag), l'aluminium (Al), le calcium (Ca) et le nickel (Ni) .

Selon un mode de réalisation, le dispositif comprend, sur un substrat, un empilement de la première portion et de la deuxième portion.

Selon un mode de réalisation, la première portion et la deuxième portion sont au contact d'un substrat.

Selon un mode de réalisation, le dispositif comprend un transistor à effet de champ comprenant un isolant de grille correspondant à la deuxième portion et une région de canal formée dans la première portion.

Selon un mode de réalisation, le dispositif comprend une capacité MIS comprenant des première et deuxième électrodes séparées par une portion diélectrique, la première portion correspondant à la première électrode ou à la deuxième électrode et la deuxième portion correspondant à la portion diélectrique.

Un mode de réalisation prévoit également un procédé de fabrication d'un dispositif électronique comprenant la formation d'au moins une première portion et d'une deuxième portion d'un oxyde métallique par un procédé sol-gel, le chauffage de la première portion à une température supérieure à une première température de façon que la première portion devienne semiconductrice et le chauffage de la deuxième portion à une température inférieure à une deuxième température, la deuxième température étant strictement inférieure à la première température, de façon que la deuxième portion devienne isolante électriquement.

Selon un mode de réalisation, le procédé comprend les étapes suivantes :
(a) formation de la deuxième portion par un procédé sol-gel et chauffage de la deuxième portion à une température inférieure à la deuxième température ; et
(b) formation de la première portion par un procédé sol-gel et chauffage de la première portion à une température supérieure à la première température.

Selon un mode de réalisation, le procédé comprend les étapes suivantes :
formation d'une couche dudit oxyde métallique par un procédé sol-gel ;
chauffage local de ladite couche à une température supérieure à la première température pour former la première portion ; et
chauffage de la couche à une température inférieure à la deuxième température pour former la deuxième portion.

Selon un mode de réalisation, l'étape de chauffage local est réalisée par laser ou rayonnement ultraviolet.

Selon un mode de réalisation, l'oxyde métallique est choisi parmi le groupe comprenant l'oxyde de zinc (ZnO), l'oxyde d'indium (In₂O₃), l'oxyde d'indium et de zinc (In-Zn-O), les oxydes In-X-Zn-O où X est choisi parmi le groupe comprenant le gallium (Ga), l'antimoine (Sb), l'étain (Sn), le magnésium (Mg), le béryllium (Be), l'yttrium (Y), l'argent (Ag), l'aluminium (Al), le calcium (Ca) et le nickel (Ni) et les oxydes Sn-X-Zn-O où X est choisi parmi le groupe comprenant le gallium (Ga), l'antimoine (Sb), le magnésium (Mg), le béryllium (Be), l'yttrium (Y), l'argent (Ag), l'aluminium (Al), le calcium (Ca) et le nickel (Ni) .

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont des vues en coupe de modes de réalisation de transistors à effet de champ ;
la figure 3 est une vue en coupe d'un mode de réalisation d'une capacité métal-isolant-semiconducteur ;
la figure 4 est une vue en coupe d'un mode de réalisation de pistes semiconductrices isolées latéralement ;
les figures 5A à 5C sont des vues en coupe de structures obtenues à des étapes successives d'un mode de réalisation d'un procédé de fabrication du transistor à effet de champ représenté en figure 1 ;
la figure 6 représente des courbes d'évolution du courant de drain en fonction de la tension de grille de transistors à effet de champ formés selon le mode de réalisation de procédé de fabrication illustré aux figures 5A à 5C pour différentes températures de séchage de la couche semiconductrice ;
la figure 7 représente une courbe d'évolution de la mobilité des électrons en fonction de la température de la couche semiconductrice formée selon le mode de réalisation de procédé de fabrication illustré aux figures 5A à 5C pour différentes températures de séchage de la couche semiconductrice ; et
les figures 8A à 8C sont des vues en coupe de structures obtenues à des étapes successives d'un mode de réalisation d'un procédé de fabrication du dispositif électronique représenté en figure 4.

### Description détaillée

Par souci de clarté, de mêmes éléments ont été désignés par de mêmes références aux différentes figures et, de plus, les diverses figures ne sont pas tracées à l'échelle. Dans la suite de la description, les expressions "sensiblement", "environ" et "approximativement" signifient "à 10 % près". En outre, on entend par "couche principalement constituée d'un matériau" ou "couche à base d'un matériau" qu'une couche comporte une proportion supérieure ou égale à 95 % dudit matériau, cette proportion étant préférentiellement supérieure à 99 %.

Dans la suite de la description, on appelle matériau isolant électriquement un matériau dont la résistivité est supérieure à 10⁵ Ω.m et on appelle matériau semiconducteur un matériau dont la résistivité électrique est comprise entre 0,1 Ω.m et 10³ Ω.m.

Le procédé sol-gel est un procédé de fabrication d'un polymère inorganique comprenant une succession de réactions d'hydrolyse et de condensation, à température modérée (en général entre 20°C et 150°C), pour obtenir des réseaux d'oxydes. La formation du réseau d'oxydes a lieu en solution. Les réactions chimiques à la base du procédé sont déclenchées lorsque des précurseurs sont mis en présence d'eau : l'hydrolyse des précurseurs intervient tout d'abord, puis la condensation des produits hydrolysés conduit à la gélification du système. Avant la gélification, la solution colloïdale de particules (1 à 1 000 nanomètres de diamètre), dans laquelle se déroulent les réactions d'hydrolyse et de condensation, est appelée sol.

Selon un mode de réalisation d'un procédé de fabrication d'un dispositif électronique comprenant une portion isolante en contact avec une portion semiconductrice, la portion isolante et la portion semiconductrice sont réalisées à base d'un même oxyde métallique obtenu selon un procédé sol-gel. Le caractère isolant ou semiconducteur est obtenu en modifiant les conditions de séchage des portions d'oxyde métallique et notamment la température de séchage. En effet, les inventeurs ont mis en évidence que, pour obtenir une portion semiconductrice, l'étape de séchage est réalisée à une température supérieure à une première température de seuil et que, pour obtenir une portion isolante, l'étape de séchage est réalisée à une température inférieure à une deuxième température de seuil strictement inférieure à la première température de seuil. Comme la portion semiconductrice et la portion isolante sont à base du même oxyde métallique, l'interface entre la portion semiconductrice et la portion isolante présente alors peu de défauts.

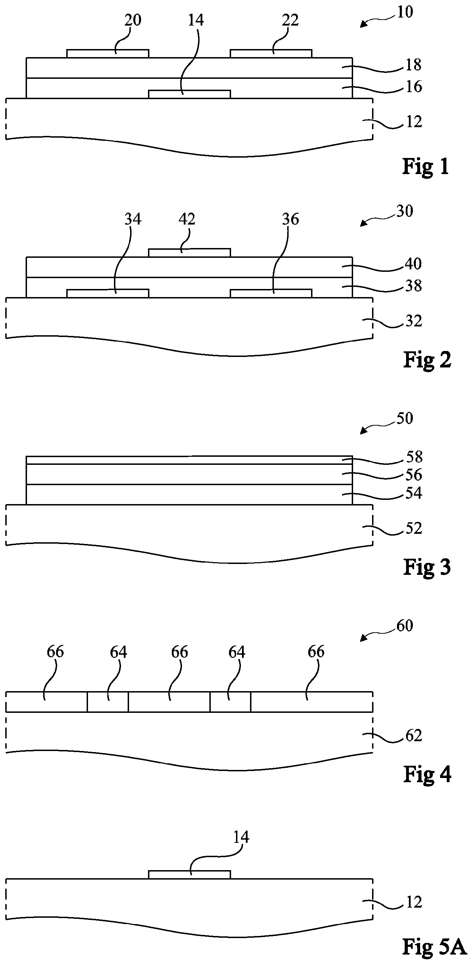

Les figures 1 à 4 illustrent des modes de réalisation de dispositifs électroniques pour lesquels le mode de réalisation du procédé de fabrication décrit précédemment peut être mis en oeuvre.

La figure 1 est une vue en coupe d'un mode de réalisation d'un dispositif électronique 10 comprenant un transistor à effet de champ dit « à grille basse ». Le dispositif électronique 10 comprend du bas vers le haut :
un substrat 12 ;
une portion conductrice 14 sur le substrat 12 ;
une couche isolante 16 recouvrant la portion conductrice 14 et le substrat 12 ;
une couche semiconductrice 18 recouvrant la couche isolante 16 ; et
des portions conductrices 20, 22 sur la couche semiconductrice 18.

La portion conductrice 14 forme la grille du transistor. La couche isolante 16 correspond à la grille du transistor. Les portions conductrices 20 et 22 forment les contacts de drain et de source du transistor. Le canal du transistor est formé dans la couche semiconductrice 18.

L'épaisseur du substrat 12 peut être comprise entre 5 µm et 1000 µm. Le substrat 12 peut être un substrat rigide ou un substrat flexible. Un exemple de substrat rigide comprend un substrat en silicium, en germanium ou en verre. De préférence, le substrat 12 est un film flexible. Un exemple de substrat flexible comprend un film en PEN (polyéthylène naphtalate), PET (polyéthylène téréphtalate), PI (polyimide) ou PEEK (polyétheréthercétone). Le substrat 12 peut avoir une épaisseur de 10 µm à 300 µm et présenter un comportement flexible, c'est-à-dire que le substrat 12 peut, sous l'action d'une force extérieure, se déformer, notamment se plier, sans se casser ou se déchirer.

Les portions conductrices 14, 20, 22 peuvent avoir une épaisseur comprise entre 20 nm et 100 nm. Elles peuvent être réalisées en oxyde d'étain et d'aluminium, en un matériau métallique, notamment en argent, en or, en nickel, en palladium, en platine, en aluminium ou un alliage ou un mélange d'au moins deux des matériaux, en un polymère conducteur, par exemple du PEDOT : PSS (le poly(3,4-éthylènedioxythiophène) : poly(styrène sulfonate)).

La couche isolante 16 a une épaisseur comprise entre 100 nm et 500 nm.

La couche semiconductrice 18 a une épaisseur comprise entre 5 nm et 40 nm.

La couche isolante 16 et la couche semiconductrice 18 sont à base d'un même oxyde métallique. La couche isolante 16 et la couche semiconductrice 18 sont à base d'un oxyde métallique susceptible d'avoir un comportement semiconducteur. Des exemples de tels oxydes métalliques sont :
l'oxyde de zinc (ZnO) ;
l'oxyde d'indium (In₂O₃) ;
l'oxyde d'indium et de zinc (In-Zn-O) ;
les oxydes In-X-Zn-O où X est choisi parmi le groupe comprenant le gallium (Ga), l'antimoine (Sb), l'étain (Sn), le magnésium (Mg), le béryllium (Be), l'yttrium (Y), l'argent (Ag), l'aluminium (Al), le calcium (Ca) et le nickel (Ni) ; et
les oxydes Sn-X-Zn-O où X est choisi parmi le groupe comprenant le gallium (Ga), l'antimoine (Sb), le magnésium (Mg), le béryllium (Be), l'yttrium (Y), l'argent (Ag), l'aluminium (Al), le calcium (Ca) et le nickel (Ni).

La figure 2 est une vue en coupe d'un mode de réalisation d'un dispositif électronique 30 comprenant un transistor à effet de champ dit « à grille haute ». Le dispositif électronique 10 comprend du bas vers le haut :
un substrat 32 ;
des portions conductrices 34, 36 sur le substrat 32 ;
une couche semiconductrice 38 recouvrant les portions conductrices 34, 36 et le substrat 32 ;
une couche isolante 40 recouvrant la couche semiconductrice 38 ; et
une portion conductrice 42 sur la couche isolante 40.

Le substrat 32, les portions conductrices 34, 36, 42, la couche semiconductrice 38 et la couche isolante 40 peuvent avoir les mêmes caractéristiques, notamment les mêmes compositions, que celles décrites précédemment respectivement pour le substrat 12, les portions conductrices 20, 22, 14, la couche semiconductrice 18 et la couche isolante 16.

La figure 3 est une vue en coupe d'un mode de réalisation d'un dispositif électronique 50 comprenant une capacité MIS. Le dispositif électronique 50 comprend du bas vers le haut :
un substrat 52 ;
une couche semiconductrice 54 recouvrant le substrat 52 ;
une couche isolante 56 recouvrant la couche semiconductrice 54 ; et
une portion conductrice 58 recouvrant la couche isolante 56.

Le substrat 52, la portion conductrice 58, la couche semiconductrice 54 et la couche isolante 56 peuvent avoir les mêmes caractéristiques, notamment les mêmes compositions, que celles décrites précédemment respectivement pour le substrat 12, la portion conductrice 14, la couche semiconductrice 18 et la couche isolante 16.

La figure 4 est une vue en coupe d'un mode de réalisation d'un dispositif électronique 60 comprenant du bas vers le haut :
un substrat 62 ;
des portions semiconductrices 64 reposant sur le substrat 62 ; et
des portions isolantes 66 reposant sur le substrat et s'étendant entre les portions semiconductrices 64.

Le substrat 62, chaque portion semiconductrice 64 et chaque portion isolante 66 peuvent avoir les mêmes caractéristiques, notamment les mêmes compositions, que celles décrites précédemment respectivement pour le substrat 12, la couche semiconductrice 18 et la couche isolante 16.

Les figures 5A à 5C illustrent des étapes successives d'un mode de réalisation d'un procédé de fabrication du transistor à effet de champ représenté en figure 1.

La figure 5A représente la structure obtenue après la formation de la portion conductrice 14 sur le substrat 12. La portion conductrice 14 peut être déposée par sérigraphie ou par jet d'encre.

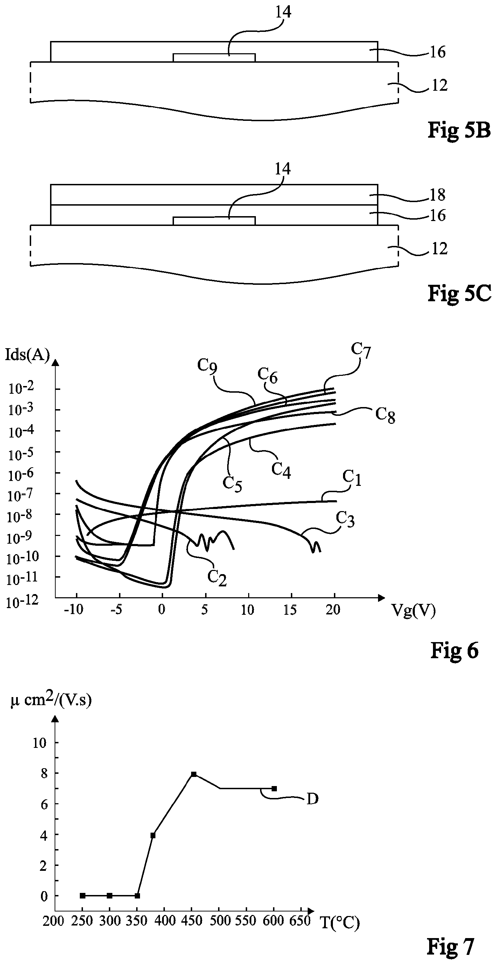

La figure 5B représente la structure obtenue après la formation de la couche isolante 16 mettant en oeuvre un procédé sol-gel.

La formation de la couche isolante 16 peut comprendre une étape de préparation d'un sol contenant l'oxyde métallique composant la couche 16, une étape de dépôt du sol et une étape de séchage du gel.

L'étape de préparation du sol peut comprendre la préparation d'une solution comprenant des précurseurs de l'oxyde métallique. Les précurseurs peuvent être des alcoxydes métalliques et/ou des sels métalliques.

A titre d'exemple, dans le cas où l'oxyde métallique est le IGZO, le précurseur du zinc peut être le dihydrate d'acétate de zinc (Zn(CH₃COO)₂.2H₂O), le précurseur du gallium peut être le nitrate de gallium hydraté (Ga(NO₃)₃.xH₂O) et le précurseur de l'indium peut être l'acétate d'indium hydraté (In(CH₃COO)₃.H₂O), ces précurseurs pouvant se présenter sous la forme de poudres. Les précurseurs sont ajoutés à un solvant de façon à former le sol. Le sol peut, en outre, comprendre un agent dispersant. Les réactions d'hydrolyse des précurseurs et de condensation des composés hydrolysés conduisent à la formation d'un réseau tridimensionnel de l'oxyde métallique. On observe une augmentation de la viscosité du sol jusqu'à l'obtention du gel. De préférence, l'étape de formation de la couche 16 est réalisée avant l'obtention du gel, lorsque le sol a la viscosité souhaitée. Selon un mode de réalisation, le gel est translucide et ne comprend pas d'agglomérats visibles à l'oeil nu.

Selon un mode de réalisation, l'étape de préparation du sol peut être effectuée à une température comprise entre 20°C et 100°C.

Le procédé de formation de la couche 16 peut correspondre à un procédé dit additif, par exemple par impression directe du sol aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de formation de la couche 16 peut correspondre à un procédé dit soustractif, dans lequel le sol est déposé sur la totalité de la structure et dans lequel les portions non utilisées sont ensuite retirées, par exemple par photolithographie ou ablation laser. Selon le matériau considéré, le dépôt sur la totalité de la structure peut être réalisé par dépôt à la tournette, revêtement par pulvérisation, héliographie, revêtement par filière (en anglais slot-die coating), revêtement à la lame (en anglais blade-coating), flexographie ou sérigraphie.

L'étape de séchage est réalisée à une température inférieure à une deuxième température de seuil au-dessous de laquelle un matériau isolant électriquement est obtenu. A titre d'exemple, pour du IGZO, la deuxième température de seuil est de l'ordre de 350°C et l'étape de séchage est réalisée à une température comprise entre 200°C et 350°C, de préférence entre 250°C et 350°C. La durée du séchage peut varier de 4 minutes à 1 heure. Le séchage peut être réalisé dans un four à l'atmosphère ambiante.

Les inventeurs ont mis en évidence que pour une telle température de séchage, le matériau à base d'oxyde métallique finalement obtenu est un isolant électrique. Une explication serait que, en raison de la température peu élevée du séchage, le gel se désorganise par la migration d'espèces chimiques. En outre, certains éléments, issus des précurseurs, peuvent être conservés dans le gel et favorisent le caractère isolant.

La figure 5C représente la structure obtenue après la formation de la couche semiconductrice 18 mettant en oeuvre un procédé sol-gel.

La formation de la couche semiconductrice 18 peut comprendre une étape de préparation d'un sol contenant l'oxyde métallique composant la couche 18, une étape de dépôt du sol et une étape de séchage du gel.

Le sol peut être préparé comme cela a été décrit précédemment en relation avec la formation de la couche isolante 16. De préférence, le sol utilisé pour la réalisation de la couche isolante 16 a la même composition que le sol utilisé pour la réalisation de la couche semiconductrice 18. Le sol utilisé pour la formation de la couche semiconductrice 18 peut être déposé selon les procédés de dépôt décrits précédemment pour la formation de la couche isolante 16.

Selon un mode de réalisation, il peut être avantageux de réaliser la couche semiconductrice 18 par des dépôts successifs de couches semiconductrices élémentaires formant un empilement, chaque dépôt étant suivi d'un séchage avant le dépôt de la couche suivante. A titre d'exemple, chaque couche semiconductrice élémentaire peut avoir, après séchage, une épaisseur comprise entre 5 nm et 10 nm.

L'étape de séchage est réalisée à une température supérieure à une première température de seuil, strictement supérieure à la deuxième température de seuil. A titre d'exemple, pour du IGZO, la première température de seuil est de l'ordre de 370°C et l'étape de séchage est réalisée à une température comprise entre 370°C et 500°C, de préférence comprise entre 400°C et 450°C. La durée du séchage peut varier de 4 minutes à 1 heure.

Selon un mode de réalisation, la durée de la montée en température depuis la température de dépôt du sol à la température de séchage est inférieure à quelques secondes.

Les inventeurs ont mis en évidence que pour une telle température de séchage, le matériau à base d'oxyde métallique finalement obtenu est un semiconducteur. Une explication serait que, en raison de la température élevée de séchage, la structure ordonnée du gel se fige rapidement. En outre, les éléments issus des précurseurs, pouvant favoriser le caractère isolant électriquement, tendent à quitter le gel par évaporation sensiblement en totalité.

De plus, les inventeurs ont mis en évidence que, bien que la température de séchage utilisée pour réaliser la couche semiconductrice 18 soit plus élevée que la température de séchage ayant été utilisée pour réaliser la couche isolante 16 à l'étape précédente, la couche 16 conserve son caractère d'isolant électrique. La couche isolante 16 peut donc être réalisée avant la couche semiconductrice 18.

La figure 6 représente des courbes d'évolution C₁ à Cg du courant de drain Ids d'un transistor à effet de champ en fonction de la tension de grille Vd, le transistor ayant la structure représentée en figure 1 et ayant été réalisé selon le procédé de fabrication décrit précédemment en relation avec les figures 5A à 5C. Pour l'obtention des courbes C₁ à Cg, le substrat 12 était le silicium et avait une épaisseur de 750 µm. Les portions conductrices 20, 22 étaient en or et la portion 14 étant en aluminium. Les portions 14, 20, 22 avaient chacune une épaisseur de 40 nm. La couche isolante 16 avait une épaisseur de 100 nm. La couche semiconductrice 18 avait une épaisseur de 15 nm. La couche isolante 16 et la couche semiconductrice 18 ont été réalisées à partir d'un sol préparé en mélangeant 30 mg de poudre de Zn(CH₃COO)₂.2H₂O, 5 mg de poudre de Ga(NO₃)₃.xH₂O, 15 mg de poudre de In(CH₃COO)₃.H₂O, 10 ml de 2-méthoxyéthanol et 0,5 ml d'éthanolamine. La solution a été agitée pendant 12 heures à 70°C. La couche isolante 16 a été déposée par impression par jet d'encre en une seule fois. La couche semiconductrice 18 a été déposée par impression par jet d'encre par plusieurs dépôts successifs, chaque dépôt étant suivi d'une étape de séchage avant le dépôt suivant. La longueur de canal du transistor était de 20 µm.

La température de séchage pour la formation de la couche isolante 16 était de 300°C et la durée de séchage pour la formation de la couche isolante 16 était de 1 heure pour toutes les courbes C₁ à Cg. La durée de séchage pour la formation de la couche semiconductrice 18 était de 450°C pour toutes les courbes C₁ à Cg. Le tableau (1) ci-dessous indique, pour chaque courbe C₁ à Cg, la température de séchage utilisée pour la formation de la couche semiconductrice 18 et la tension Vds appliquée entre le drain et la source du transistor.

**Tableau (1)**

| Courbes | C₁ | C₂ | C₃ | C₄ | C₅ | C₆ | C₇ | C₈ | C₉ |
|---|---|---|---|---|---|---|---|---|---|
| Température de séchage (°C) | 200 | 300 | 300 | 350 | 350 | 380 | 380 | 450 | 450 |
| Vds (V) | 20 | 1 | 20 | 1 | 20 | 1 | 20 | 1 | 20 |

Les courbes C₄ à Cg sont caractéristiques d'un transistor à effet de champ, ce qui traduit bien le fait que la couche 16 est composée d'un matériau isolant tandis que la couche 18 est composée d'un matériau semiconducteur.

Les courbes C₁ à C₃ montrent une absence de conduction du transistor MOS ce qui signifie que le matériau composant la couche 18 n'a pas un comportement semiconducteur mais isolant.

La figure 7 représente une courbe d'évolution D de la mobilité µ des électrons dans la couche semiconductrice 18 en fonction de la température de séchage utilisée pour la formation de cette couche, la couche 18 ayant été préparée selon le procédé décrit précédemment en relation avec la figure 6. La mobilité µ des électrons était sensiblement égale à 0 lorsque la température de séchage de la couche 18 était inférieure à 350°C et la mobilité µ des électrons était supérieure à 4 cm²/(V.s) lorsque la température de séchage de la couche 18 était supérieure à 370°C. Ceci signifie que le matériau composant la couche 18 se comporte comme un isolant électrique lorsque la température de séchage pour la formation de la couche 18 est inférieure à environ 350°C et se comporte comme un semiconducteur lorsque la température de séchage pour la formation de la couche est supérieure à environ 370°C.

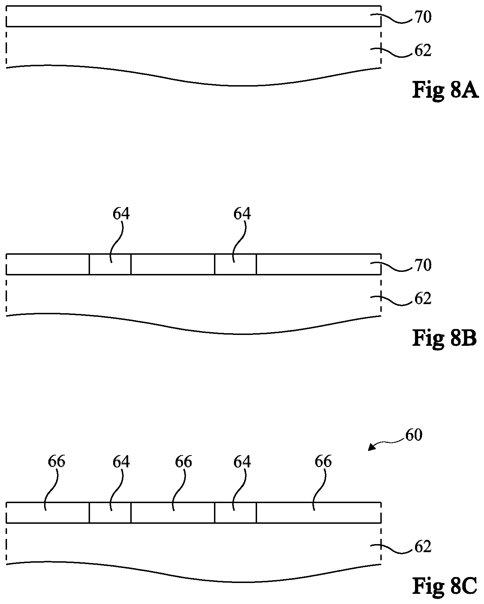

Les figures 8A à 8C sont des vues avec coupe de structures obtenues à des étapes successives d'un mode de réalisation d'un procédé de fabrication du dispositif électronique 60 représenté en figure 4.

La figure 8A représente la structure obtenue après le dépôt d'une couche 70 d'un sol tel que décrit précédemment sur le substrat 62.

La figure 8B représente la structure obtenue après une étape de chauffage local de la couche 70 pour former les portions semiconductrices 64. L'étape de chauffage peut consister à chauffer brièvement la couche 70 aux emplacements où des portions semiconductrices 64 sont souhaitées. Le chauffage local peut être réalisé par un laser, notamment un laser à excimère avec une puissance de l'ordre de 100 watts. Le chauffage local peut être réalisé par un rayonnement ultraviolet (UV) au travers d'un masque, notamment au moins une brève impulsion d'ultraviolet à l'aide de l'équipement commercialisé sous l'appellation PulseForge par la société Novacentrix ou sous l'appellation Sinteron 2000 par la société Xenon Corporation. Plusieurs flashs ultraviolets peuvent être réalisés. Par rayonnement UV, on entend un rayonnement dont les longueurs d'onde sont, au moins en partie, comprises entre 200 nm et 400 nm. A titre d'exemple, le rayonnement ultraviolet est appliqué avec des impulsions brèves, par exemple entre 500 µs et 3 ms, avec une fluence comprise entre 1 J/cm² et 30 J/cm².

Par ces divers moyens, on amène très brièvement la température des portions semiconductrices 64 dans la couche 70 à une température supérieure à 370°C. Le chauffage est suffisamment intense et bref pour que la température du reste de la couche 70 ne s'élève pas au-delà de 370°C.

La figure 8C représente la structure obtenue après une étape de chauffage global de la couche 70 à une température inférieure à 350°C de façon à former les portions isolantes 66.

Selon une variante, les opérations décrites précédemment en relation avec les figures 8A à 8C peuvent être répétées plusieurs fois pour obtenir des portions semiconductrices 64 ayant l'épaisseur souhaitée.

## Revendications

1. Procédé de fabrication d'un dispositif électronique (10 ; 30 ; 50 ; 60) comprenant la formation d'au moins une première portion (18 ; 38 ; 54 ; 64) et d'une deuxième portion (16 ; 40 ; 56 ; 66) à base d'un oxyde métallique par un procédé sol-gel, le chauffage de la première portion à une température supérieure à une première température de façon que la première portion devienne semiconductrice et le chauffage de la deuxième portion à une température inférieure à une deuxième température, la deuxième température étant strictement inférieure à la première température, de façon que la deuxième portion devienne isolante électriquement.

2. Procédé selon la revendication 1, dans lequel, avant chauffage, la première portion et la deuxième portion ont la même composition.

3. Procédé selon la revendication 1 ou 2, comprenant les étapes successives suivantes :
(a) formation de la deuxième portion (16 ; 40 ; 56) par un procédé sol-gel et chauffage de la deuxième portion à une température inférieure à la deuxième température ; et
(b)formation de la première portion (18 ; 38 ; 54) par un procédé sol-gel et chauffage de la première portion à une température supérieure à la première température.

4. Procédé selon la revendication 1 ou 2, comprenant les étapes suivantes :
formation d'une couche (70) à base dudit oxyde métallique par un procédé sol-gel ;
chauffage local de ladite couche à une température supérieure à la première température pour former la première portion (64) ; et
chauffage de la couche à une température inférieure à la deuxième température pour former la deuxième portion (66).

5. Procédé selon la revendication 4, dans lequel l'étape de chauffage local est réalisée par laser ou rayonnement ultraviolet.

6. Procédé selon l'une quelconque des revendications 1 à 5, dans lequel l'oxyde métallique est choisi parmi le groupe comprenant l'oxyde de zinc (ZnO), l'oxyde d'indium (In203), l'oxyde d'indium et de zinc (In-Zn-O), les oxydes In-X-Zn-O où X est choisi parmi le groupe comprenant le gallium (Ga), l'antimoine (Sb), l'étain (Sn), le magnésium (Mg), le béryllium (Be), l'yttrium (Y), l'argent (Ag) , l'aluminium (Al), le calcium (Ca) et le nickel (Ni) et les oxydes Sn-X-Zn-O où X est choisi parmi le groupe comprenant le gallium (Ga), l'antimoine (Sb), le magnésium (Mg), le béryllium (Be), l'yttrium (Y), l'argent (Ag), l'aluminium (Al), le calcium (Ca) et le nickel (Ni).

7. Dispositif électronique (10 ; 30 ; 50 ; 60) réalisé selon le procédé de l'une quelconque des revendications 1 à 6.

8. Dispositif électronique selon la revendication 7, dans lequel la première portion (18 ; 38 ; 54 ; 64) est au contact de la deuxième portion (16 ; 40 ; 56 ; 66).

9. Dispositif électronique selon la revendication 8, comprenant, sur un substrat (12 ; 32 ; 52) , un empilement de la première portion (18 ; 38 ; 54) et de la deuxième portion (16 ; 40 ; 56) .

10. Dispositif électronique selon la revendication 8 ou 9, dans lequel la première portion (64) et la deuxième portion (66) sont au contact d'un substrat (62).

11. Dispositif électronique selon la revendication 8 ou 9, comprenant un transistor à effet de champ comprenant un isolant de grille correspondant à la deuxième portion (16 ; 40) et une région de canal formée dans la première portion (18 ; 38).

12. Dispositif électronique selon la revendication 8 ou 9, comprenant une capacité MIS comprenant des première et deuxième électrodes (54, 58) séparées par une portion diélectrique (56), la première portion correspondant à la première électrode ou à la deuxième électrode et la deuxième portion (56) correspondant à la portion diélectrique.

## Patentansprüche

1. Ein Verfahren zur Herstellung einer elektronischen Einrichtung (10; 30; 50; 60), das Folgendes aufweist:
Bilden mindestens eines ersten Abschnitts (18; 38; 54; 64) und eines zweiten Abschnitts (16; 40; 56; 66) auf der Basis eines Metalloxids durch ein Sol-Gel-Verfahren, Erhitzen des ersten Abschnitts auf eine Temperatur, die höher als eine erste Temperatur ist, so dass der erste Abschnitt zu einem Halbleiter wird, und das Erhitzen des zweiten Abschnitts auf eine Temperatur, die niedriger als eine zweite Temperatur ist, wobei die zweite Temperatur niedriger als die erste Temperatur ist, so dass der zweite Abschnitt elektrisch isolierend wird.

2. Verfahren nach Anspruch 1, wobei vor dem Erhitzen der erste Abschnitt und der zweite Abschnitt die gleiche Zusammensetzung haben.

3. Verfahren nach Anspruch 1 oder 2, das die folgenden aufeinanderfolgenden Schritte aufweist:
(a) Bilden des zweiten Abschnitts (16; 40; 56) durch ein Sol-Gel-Verfahren und Erhitzen des zweiten Abschnitts auf eine Temperatur, die niedriger als die zweite Temperatur ist; und
(b) Bilden des ersten Abschnitts (18; 38; 54) durch ein Sol-Gel-Verfahren und Erhitzen des ersten Abschnitts auf eine Temperatur, die höher als die erste Temperatur ist.

4. Verfahren nach Anspruch 1 oder 2, das die folgenden Schritte aufweist:
Bilden einer Schicht (70) auf der Basis des Metalloxids durch ein Sol-Gel-Verfahren;
lokales Erhitzen der Schicht auf eine Temperatur, die höher als die erste Temperatur ist, um den ersten Abschnitt (64) zu bilden; und
Erhitzen der Schicht auf eine Temperatur, die niedriger als die zweite Temperatur ist, um den zweiten Abschnitt (66) zu bilden.

5. Verfahren nach Anspruch 4, wobei der lokale Erhitzungsschritt durch Laser- oder Ultraviolettstrahlung durchgeführt wird.

6. Verfahren nach einem der Ansprüche 1 bis 5, wobei das Metalloxid aus der Gruppe ausgewählt wird, die Folgendes aufweist: Zinkoxid (ZnO), Indiumoxid (In203), Indiumzinkoxid (In-Zn-O), In-X-Zn-O-Oxide, wobei X aus der Gruppe ausgewählt wird, die Gallium (Ga), Antimon (Sb), Zinn (Sn), Magnesium (Mg), Beryllium (Be), Yttrium (Y), Silber (Ag), Aluminium (Al), Kalzium (Ca) und Nickel (Ni) aufweist, und Sn-X-Zn-O-Oxide, wobei X aus der Gruppe ausgewählt ist, die Gallium (Ga), Antimon (Sb), Magnesium (Mg), Beryllium (Be), Yttrium (Y), Silber (Ag), Aluminium (Al), Kalzium (Ca) und Nickel (Ni) aufweist.

7. Eine elektronische Einrichtung (10; 30; 50; 60), die nach dem Verfahren nach einem der Ansprüche 1 bis 6 hergestellt wurde.

8. Elektronische Einrichtung nach Anspruch 7, wobei der erste Abschnitt (18; 38; 54; 64) mit dem zweiten Abschnitt (16; 40; 56; 66) in Kontakt ist.

9. Elektronische Einrichtung nach Anspruch 8, die auf einem Substrat (12; 32; 52) einen Stapel aus dem ersten Abschnitt (18; 38; 54) und dem zweiten Abschnitt (16; 40; 56) aufweist.

10. Elektronische Einrichtung nach Anspruch 8 oder 9, wobei der erste Abschnitt (64) und der zweite Abschnitt (66) mit einem Substrat (62) in Kontakt sind.

11. Elektronische Einrichtung nach Anspruch 8 oder 9, die einen Feldeffekttransistor aufweist, der einen Gate-Isolator, der dem zweiten Abschnitt (16; 40) entspricht, und einen im ersten Abschnitt (18; 38) gebildeten Kanalbereich aufweist.

12. Elektronische Einrichtung nach Anspruch 8 oder 9 die einen MIS-Kondensator aufweist, der eine erste und eine zweite Elektrode (54, 58) aufweist, die durch einen dielektrischen Abschnitt (56) getrennt sind, wobei der erste Abschnitt der ersten Elektrode oder der zweiten Elektrode entspricht und der zweite Abschnitt (56) dem dielektrischen Abschnitt entspricht.

## Claims

1. A method of manufacturing an electronic device (10; 30; 50; 60) comprising forming at least a first portion (18; 38; 54; 64) and a second portion (16; 40; 56; 66) based on a metal oxide by a sol-gel method, heating the first portion up to a temperature higher than a first temperature so that the first portion becomes semiconductor and heating the second portion up to a temperature lower than a second temperature, the second temperature being lower than the first temperature, so that the second portion becomes electrically insulating.

2. The method of claim 1, wherein, before the heating, the first portion and the second portion have the same composition.

3. The method of claim 1 or 2, comprising the successive steps of:
(a) forming the second portion (16; 40; 56) by a sol-gel method and heating the second portion up to a temperature lower than the second temperature; and
(b) forming the first portion (18; 38; 54) by a sol-gel method and heating the first portion up to a temperature higher than the first temperature.

4. The method of claim 1 or 2, comprising the steps of:
forming a layer (70) based on said metal oxide by a sol-gel method;
locally heating said layer up to a temperature higher than the first temperature to form the first portion (64); and
heating the layer up to a temperature lower than the second temperature to form the second portion (66).

5. The method of claim 4, wherein the local heating step is carried out by laser or ultraviolet radiation.

6. The method of any of claims 1 to 5, wherein the metal oxide is selected from the group comprising zinc oxide (ZnO) , indium oxide (In203), indium zinc oxide (In-Zn-O), In-X-Zn-O oxides, where X is selected from the group comprising gallium (Ga) , antimony (Sb) , tin (Sn), magnesium (Mg), beryllium (Be), yttrium (Y), silver (Ag), aluminum (Al), calcium (Ca), and nickel (Ni), and Sn-X-Zn-O oxides, where X is selected from the group comprising gallium (Ga), antimony (Sb), magnesium (Mg), beryllium (Be), yttrium (Y), silver (Ag), aluminum (Al), calcium (Ca), and nickel (Ni).

7. An electronic device (10; 30; 50; 60) formed according to the method of any of claims 1 to 6.

8. The electronic device of claim 7, wherein the first portion (18; 38; 54; 64) is in contact with the second portion (16; 40; 56; 66).

9. The electronic device of claim 8, comprising, on a substrate (12; 32; 52), a stack of the first portion (18; 38; 54) and of the second portion (16; 40; 56).

10. The electronic device of claim 8 or 9, wherein the first portion (64) and the second portion (66) are in contact with a substrate (62).

11. The electronic device of claim 8 or 9, comprising a field-effect transistor comprising a gate insulator corresponding to the second portion (16; 40) and a channel region formed in the first portion (18; 38).

12. The electronic device of claim 8 or 9, comprising a MIS capacitor comprising first and second electrodes (54, 58) separated by a dielectric portion (56), the first portion corresponding to the first electrode or to the second electrode and the second portion (56) corresponding to the dielectric portion.
